# EUROPEAN PATENT SPECIFICATION

(11) **EP 2 928 080 B1**
(45) Date of publication and mention of the grant of the patent: **28.11.2018**
(21) Application number: 15161767.7
(22) Date of filing: 30.03.2015
(51) Int. Cl.: H03K 17/96, C09J 9/02, H05K 3/32

(54) **CAPACITIVE TOUCH-SENSITIVE DEVICE**
KAPAZITIVE BERÜHRUNGSEMPFINDLICHE VORRICHTUNG
DISPOSITIF TACTILE CAPACITIF

(30) Priority: 31.03.2014 CN 201410127708
(43) Date of publication of application: 07.10.2015
(73) Proprietor: TPK Universal Solutions Limited, Hong Kong (HK)
(72) Inventor: Kao, Kuo-Feng, Xinbei City (TW); Huang, Sung-Chien, Taoyuan City (TW); Leong, Wee-Hong, Kuala Lumpur (MY); Wu, Shiang-Ting, Pingzhen City Taoyuan County (TW)
(74) Representative: Goddar, Heinz J.

(56) References cited:
- EP-A2- 1 772 889
- US-A- 3 132 204
- US-A1- 2005 228 144
- US-A1- 2011 315 536

## Description

### BACKGROUND OF THE INVENTION

This application claims priority to Chinese Application Serial Number 201410127708.3, filed on March 31, 2014.

### FIELD OF THE INVENTION

The disclosure relates to touch-sensitive technology, more particularly to a capacitive touch-sensitive device with stable signal transmission.

### RELATED ART OF INVENTION

US2011/0315536A1 refers to a touch panel including first and a second patterned conductive layers, the first patterned conductive layer including first sensing series, and the second patterned conductive layer including second sensing series. A circuit board includes a rigid portion and flexible bonding portions. The flexible bonding portions are electrically connected to the first and second sensing series, respectively, in bonding areas. For the purpose of electrical coupling, anisotropic films are disposed between ends of the sensing series and their respective bonding portions.

Referring to Figure 1, U.S. Patent Application Publication No. 20010046021A1 discloses a conventional anisotropic conductive film 1 (ACF), which includes an insulative adhesive layer 11 which is made from resin, and a plurality of metal conductor particles 12 dispersed in the insulative adhesive layer 11. Such conventional anisotropic conductive film 1 is mainly adapted to be disposed between a capacitive touch-sensitive device and a flexible printed circuit board (FPC) to electrically and correspondingly connect signal lines of the capacitive touch-sensitive device with bonding pads of the flexible printed circuit board (i.e., to perform bonding), such that vertical pairs of the signal lines and bonding pads are electrically connected while adjacent signal lines or adjacent bonding pads are not.

Skilled artisans in the art tend to reduce the particle diameter of the metal conductor particles 12 to further prevent line-to-line or pad-to-pad connections from the conventional anisotropic conductive film 1, so as to increase precision of signal transmission.

With development of the technology, nano-metals are gradually adopted for making the signal lines instead of silver pastes or copper. However, when the conventional anisotropic conductive film 1 bridges the signal lines of the capacitive touch-sensitive device and the bonding pads of the flexible printed circuit board, the signal lines made of the nano-metals with a relative low density may result in problems such as unstable signal transmission or open circuit.

From the description above, it is clear that improving the bridging efficiency between the signal lines and the flexible circuit board to overcome the problems such as open circuit of signals and instability of signals may be a task for the skilled artisans.

### SUMMARY OF THE INVENTION

Therefore, an object of the disclosure is to provide a capacitive touch-sensitive device that may alleviate at least one of the drawbacks of the prior arts.

This is done by a capacitive touch-sensitive device according to claim 1.

### BRIEF DESCRIPTION OF THE DRAWINGS

Other features and advantages of the disclosure will become apparent in the following detailed description of the exemplary embodiments with reference to the accompanying drawings, of which:

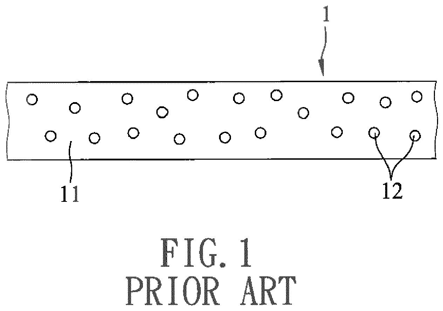

Figure 1 is a fragmentary schematic sectional view of a conventional anisotropic conductive film disclosed in U.S. Application Publication No. 20010046021A1;
Figure 2 is a top schematic view of a first exemplary embodiment of a capacitive touch-sensitive device according to the present disclosure;
Figure 3 is a fragmentary sectional schematic view of the capacitive touch-sensitive device taken along line III-III in Figure 2;
Figure 4 is a partly enlarged view of Figure 2;
Figure 5 is a fragmentary schematic diagram of the first exemplary embodiment, illustrating a plurality of spherical-shaped first conductors;
Figure 6 is a schematic diagram of a second exemplary embodiment according to the present disclosure, illustrating that the first conductors are configured as spiked spheres;
Figure 7 is a schematic diagram of a third exemplary embodiment according to the present disclosure, illustrating that the first conductors are configured as wires;
Figure 8 is a top schematic view of a fourth exemplary embodiment of the capacitive touch-sensitive device according to the present disclosure, illustrating a sensor electrode layer;
Figure 9 is a fragmentary perspective view of the fourth exemplary embodiment, illustrating the detail structure of the sensor electrode layer; and
Figure 10 is a top schematic view of a seventh exemplary embodiment of the capacitive touch-sensitive device according to the present disclosure.

### DETAILED DESCRIPTION OF THE DISCLOURES

Before the disclosure is described in greater detail, it should be noted that like elements are denoted by the same reference numerals throughout the disclosure.

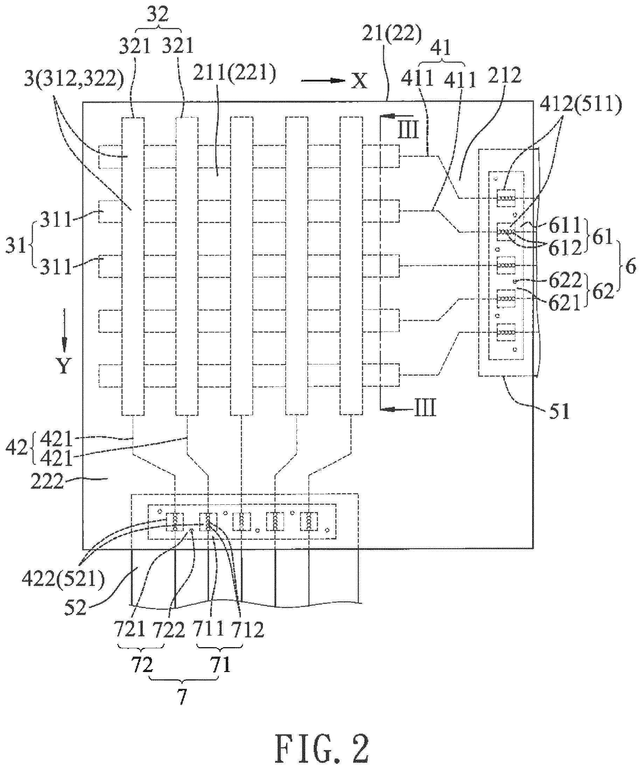

Referring to Figures 2 to 5, a first exemplary embodiment of a capacitive touch-sensitive device according to the present disclosure is adapted to be disposed at a front side of a flat panel display (FPD) to constitute a touch panel, and to allow a user to control the same using his/her finger(s) from the front side of the flat panel display. The capacitive touch-sensitive device of the first exemplary embodiment includes a lower transparent substrate 21, an upper transparent substrate 22, a lower sensor electrode layer 31, an upper sensor electrode layer 32, a lower signal trace layer 41, an upper signal trace layer 42, a lower flexible circuit board 51, an upper flexible circuit board 52, a lower electrically-conductive adhesive layer 6, an upper electrically-conductive adhesive layer 7, a transparent cover plate 8, a lower optical adhesive layer 91 and an upper optical adhesive layer 92. The transparent cover plate 8 covers the lower and upper sensor electrode layers 31, 32 and the lower and upper signal trace layers 41, 42. The lower optical adhesive layer 91 is attached to and between the lower and upper sensor electrode layers 31, 32, and the upper optical adhesive layer 92 is attached to and between the upper transparent substrate 22 and the transparent cover plate 8. Simply put, in this embodiment, the capacitive touch-sensitive device is configured into a double ITO (DITO) structure.

The lower and upper transparent substrates 21, 22 are spaced apart from and face each other, each having a viewable zone 211, 221 and a trace zone 212, 222 adjacent to the viewable zone 211, 221. Suitable materials for making the upper and lower transparent substrates 21, 22 may include, but are not limited to, polyethylene terephthalate (PET), polyethersulfones, polymethyl acrylate, polymethyl naphthalate, polyphenylene sulfide (PPS), polyallyl polymer, polycarbonate(PC) and glass.

The lower and upper sensor electrode layers 31, 32 are respectively formed on the lower and upper transparent substrates 21, 22. The lower sensor electrode layer 31 has a plurality of mutually electrically isolated first sensor lines 311, and the upper sensor electrode layer 32 has a plurality of mutually electrically isolated sensor lines 321. Each of the first and second sensor lines 311, 321 has a plurality of sensing zones 312, 322 that are spaced apart from each other. The first sensor lines 311 extend along a first direction (X), are disposed at the viewable zone 211 of the lower transparent substrate 21, and are arranged to be mutually spaced apart along a second direction (Y) substantially perpendicular to the first direction (X). The second sensor lines 321 extend along the second direction (Y), are disposed at the viewable zone 221 of the upper transparent substrate 22, and are arranged to be mutually spaced apart along the first direction (X), such that the sensing zones 322 of the second sensor lines 32 correspondingly overlap the sensing zones 312 of the first sensor lines 31 to constitute multiple capacitive sensing zones 3. In this embodiment, the lower and upper sensor electrode layers 31, 32 may be made of a transparent conductive material. Examples of the transparent conductive material may include, but are not limited to, indium tin oxide (ITO), indium zinc oxide (IZO), cadmium tin oxide (CTO), aluminum zinc oxide (AZO), indium tin zinc oxide (ITZO), zinc oxide, cadmium oxide (CdO), hafnium oxide (HfO), indium gallium zinc oxide (InGaZnO), indium gallium zinc magnesium oxide (InGaZnMgO), indium gallium magnesium oxide (InGaMgO), indium gallium aluminum oxide (InGaAlO), silver nano-wires, carbon nano-tubes and graphenes.

The lower and upper signal trace layers 41, 42 are respectively formed at the lower and upper transparent substrates 21, 22. The lower signal trace layer 41 includes a plurality of mutually electrically isolated first signal lines 411, and the upper signal trace layer 42 includes a plurality of mutually electrically isolated signal lines 421. Each of the first and second signal lines 411, 421 has an outer terminal portion 412, 422. The outer terminal portions 412 of the first signal lines 411 extend along the first direction (X), and the outer terminal portions 422 of the second signal lines 421 extend along the second direction (Y). In addition, the outer terminal portions 412 of the first signal lines 411 are mutually spaced apart in the second direction (Y) and are correspondingly connected to the first sensor lines 311 of the lower sensor electrode layer 31. The outer terminal portions 422 of the second signal lines 421 are mutually spaced apart in the first direction (X) and are correspondingly connected to the second sensor lines 321 of the upper sensor electrode layer 32. In this embodiment, the first signal lines 411of the lower signal trace layer 41 are disposed at the trace zone 212 of the lower transparent substrate 21, and the second signal lines 421 of the upper signal trace layer 42 are disposed at the trace zone 222 of the upper transparent substrate 22. It is worth noting that, in other embodiments, the trace zone 212 of the lower transparent substrate 21 and the trace zone 222 of the upper transparent substrate 22 may be formed at various positions of the corresponding substrate based on various tracing demands of the touch-sensitive device and is not limited to what is described herein.

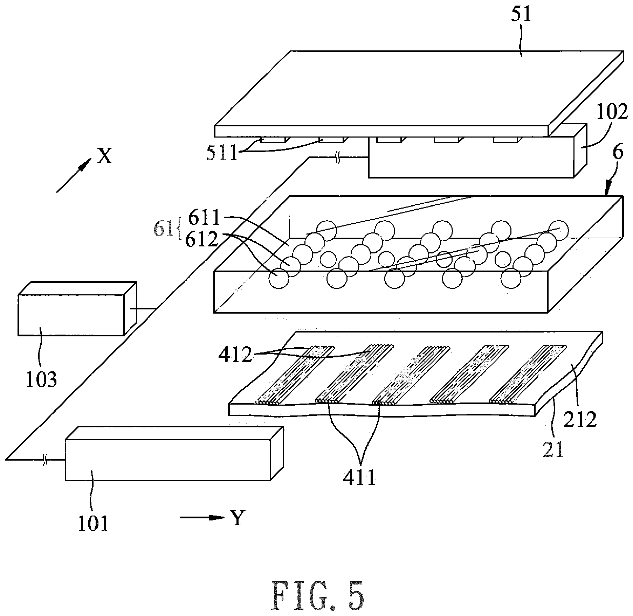

Preferably, as shown in Figure 5, the first and second signal lines 411, 421 of the lower and upper signal trace layers 41, 42 are made from nano-metals , such as silver nano-wires. In this embodiment, the silver nano-wires have a diameter ranging from 20 µm to 80 µm.

Referring back to Figure 2, the lower flexible circuit board 51 includes a plurality of mutually electrically isolated bonding pads 511, each corresponding in position to the outer terminal portion 412 of a respective one of the first signal lines 411. Similarly, the upper flexible circuit board 52 includes a plurality of mutually electrically isolated bonding pads 521, each corresponding in position to the outer terminal portion 422 of a respective one of the second signal lines 421.

The lower electrically-conductive adhesive layer 6 is disposed between the outer terminal portions 412 of the first signal lines 41 and the lower flexible circuit board 51, and has a plurality of first zones 61 that are spaced apart from each other and that respectively correspond to the outer terminal portions 412 of the first signal lines 411, and a plurality of second zones 62 that are respectively disposed between adjacent pairs of the firs zones 61. Each of the first zones 61 has a first adhesive matrix 611 and a plurality of first conductors 612 dispersed in the first adhesive matrix 611. Each of the second zones 62 has a second adhesive matrix 621 and a plurality of second conductors 622 dispersed in the second adhesive matrix 621. Through the first conductors 612 of the first zones 61, the outer terminal portions 412 of the first signal lines 41 are bonded respectively to the bonding pads 511 of the lower flexible circuit board 51.

The upper electrically-conductive adhesive layer 7 is disposed between the outer terminal portions 422 of the upper signal trace layer 42 and the upper flexible circuit board 52, and has a plurality of first zones 71 that are spaced apart from each other and that respectively correspond to the outer terminal portions 422 of the second signal lines 421, and a plurality of second zones 72 that are respectively disposed between adjacent pairs of the first zones 71. Each of the first zones 71 has a first adhesive matrix 711 and a plurality of first conductors 712 dispersed in the first adhesive matrix 711. Each of the second zones 72 has a second adhesive matrix 721 and a plurality of second conductors 722 dispersed in the second adhesive matrix 721. Through the first conductors 711 of the first zones 71, the outer terminal portions 422 of the second signal lines 42 are bonded respectively to the bonding pads 521 of the upper flexible circuit board 52.

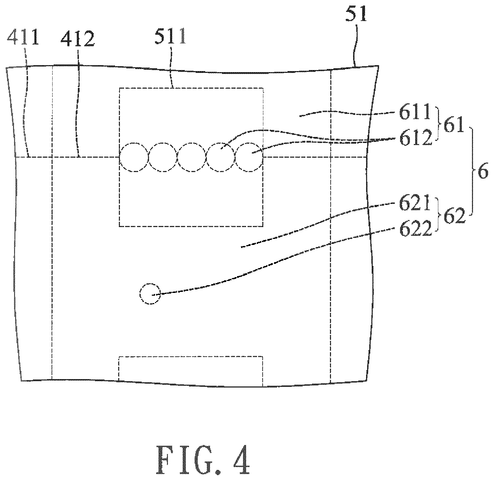

Preferably, a dispersion density of the first conductors 612, 712 in each of the first zones 61, 71 of the lower and upper electrically-conductive adhesive layers 6, 7 is greater than that of the second conductors 622, 722 in each of the second zones 62, 72 (as shown in Figure 4, where only the lower electrically-conductive adhesive layer 6 is illustrated; in addition, only one second conductor 622 is shown for the sake of brevity). More preferably, the dispersion density of the first conductors 612, 712 in each of the first zones 61, 71 ranges from 750 N(number)/mm² to 4500 N/mm², and the dispersion density of the second conductors 622, 722 in each of the second zones 62, 72 is less than 750 N/mm². In this embodiment, the first conductors 612, 712 of each of the first zones 61, 71 are mutually electrically coupled, and the second conductors 622, 722 of each of the second zones 62, 72 are mutually electrically isolated.

The first conductors 612, 712 suitable for this disclosure may be configured as spheres, spiked spheres, or wires. In this embodiment, the first adhesive matrixes 611, 711 and the second adhesive matrixes 621, 721 are made of a transparent resin material, and the first conductors 612, 712 are configured as spheres having an average diameter ranging from 20 µm to 45 µm. The first conductors 612 in each of the first zones 61 of the lower electrically-conductive adhesive layer 6 are sequentially arranged into multiple rows, in which the first conductors 612 contact each other and are arranged substantially parallel to an axial direction (i.e., the first direction (X)) of the outer terminal portions 412 of the first signal lines 411 (i.e., silver nano-wires in this embodiment). The first conductors 712 in each of the first zones 71 of the upper electrically-conductive adhesive layer 7 are sequentially arranged into multiple rows, in which the first conductors 712 contact each other and are arranged substantially parallel to an axial direction (i.e., the second direction (Y)) of the outer terminal portions 422 of the second signal lines 421 (i.e., silver nano-wires in this embodiment).

In greater detail, for instance, as illustrated in Figure 5, when disposing the lower electrically-conductive adhesive layer 6 between the outer terminal portions 412 of the first signal lines 411 and the lower flexible circuit board 6, a pair of electrode plates 101, 102 can be simultaneously provided at outer sides of the lower electrically-conductive adhesive layer 6 to be substantially parallel to the second direction (Y). A power supply 103 electrically connected to the electrode plats 101, 102 may be used for providing electrical energy to the electrode plates 101, 102 such that an electric field is generated between the electrode plates 101, 102, so as to arrange the first conductors 612 into the multiple rows substantially along the first direction (X).

From the description of the first exemplary embodiment above, by simultaneously tuning, for the first conductors 612, 712 in the first zones 61, 71, the dispersion density (e.g., greater than the dispersion density of the second conductors 622, 722 in the second zones 62, 72), the average diameter (e.g., ranging from 20µm to 45µm) and arrangement (e.g., parallel rows along the first direction (X) or the second direction (Y)) and utilizing the metal nano-wires (such as silver nano-wires) as the first and second signal lines 411, 421 of the first and second signal trace layers 41, 42, conducting areas between the first conductors 612, 712 of the first and second zones 61, 71 and the outer terminal portions 412, 422 of the first and second signal trace layers 41, 42 can be assured to be greater than 500 µm². As such, the above-mentioned problems associated with the prior art, such as instability of signal transmission or open circuit can be alleviated. It is worth noting that, the aforesaid tuning factors, such as the dispersion density, the average diameter and the arrangement of the first conductors 612, 712 are not necessarily to be simultaneously adopted. That is, in other embodiments, one or more of the tuning factors may be selected to improve the conducting areas between the first conductors 612, 712 and the outer terminal portions 412, 422 of the lower and upper signal trace layers 41, 42.

It is specifically worth noting that, in this embodiment, the lower and upper electrically-conductive adhesive layers 6, 7 may be used as anisotropic electrically-conductive films (ACFs).

It should be further noted that, in this embodiment, although the second adhesive matrixes 621, 721 of the second zones 62, 72 of the electrically-conductive adhesive layers 6, 7 have the second conductors 622, 722 dispersed therein, stability of signal transmission of the capacitive touch-sensitive device can be further assured by removing the second conductors 622, 722 from the second adhesive matrixes 621, 721 (e.g., using laser devices to burn off the second conductors), so as to prevent electrical connections between adjacent two of the bonding pads 511, 521 or even between adjacent two of the outer terminal portions 412, 422 of the first and second signal lines 411, 412 when bonding the lower and upper electrically-conductive adhesive layers 6, 7 correspondingly to the lower and upper flexible circuit boards 51, 52 and to the outer terminal portions 412, 422 of the lower and upper signal trace layers 41, 42.

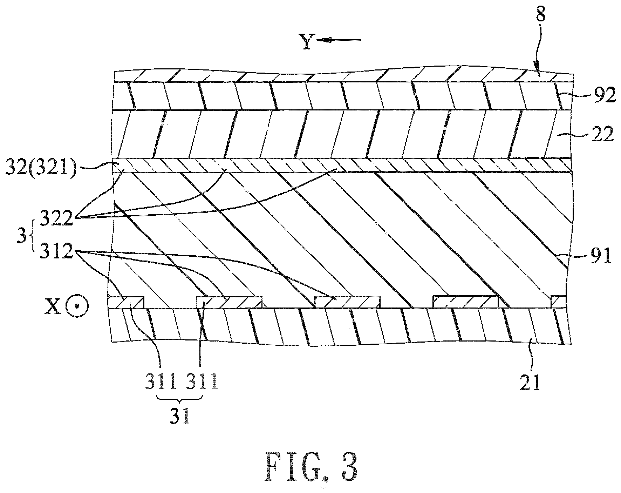

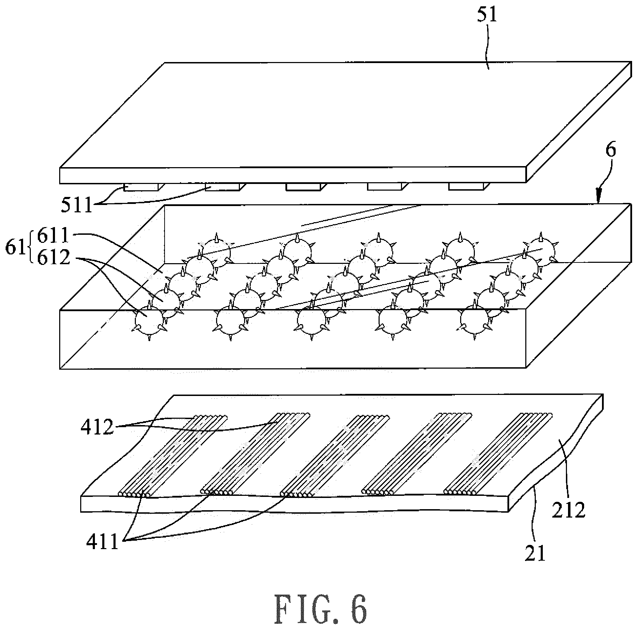

Referring to Figure 6, a second exemplary embodiment of the capacitive touch-sensitive device according to the present disclosure is shown to be substantially similar to that of the first exemplary embodiment (as shown in Figures 2 and 3), with the difference residing in that the first conductors 612, 712 are configured as spiked spheres. The number of spikes formed on the first conductors 612, 712 may vary in different embodiments and is not limited to what is illustrated in the drawings according to the present disclosure. The main purpose to configure the first conductors 612, 712 as spiked spheres is to further increase the surface area of the first conductors 612, 712, so as to increase the conducting areas between the first conductors 612, 712 of the first zones 61, 71 and the outer terminal portions 412, 422 of the lower and upper signal trace layers 41, 42.

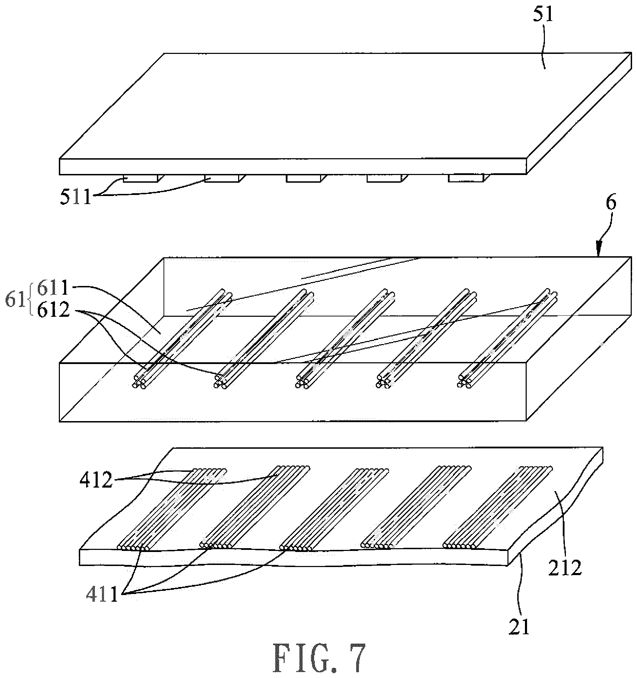

Referring to Figure 7, a third exemplary embodiment of the capacitive touch-sensitive device according to the present disclosure is shown to be similar to that of the first exemplary embodiment (as shown in Figures 2 and 3). The difference resides in that the first conductors 612, 712 are configured as wires. In addition, the first conductors 612 are arranged into multiple bundles, and an axial direction of each of the first conductors 612 is substantially parallel to the axial direction of the outer terminal portions 412 of the first signal lines 411 (i.e., the first direction (X)). The first conductors 712 are arranged into multiple bundles, and an axial direction of each of the first conductors 712 is substantially parallel to the axial direction of the outer terminal portions 422 of the second signal lines 421 (i.e., the second direction (Y)). In this embodiment, the first conductors 612, 712are silver nano-wires. Similarly, the main purpose to so configure the first conductors 612, 712 is to assure that the first conductors 612, 712 can be correspondingly arranged along the axial directions of the outer terminal portions 412, 422 of the signal lines 411, 421, so as to further increase the conducting areas between the first conductors 612, 712 of the first zones 61, 71 and the outer terminal portions 412, 422 of the lower and upper signal trace layers 41, 42.

It is worth noting that the first conductors 612, 712 of the second (or third) exemplary embodiment may be arranged in the multiple rows correspondingly along the first direction (X) and the second direction (Y) using the aforesaid method of the first exemplary embodiment (i.e., utilizing external electric field by electrode pads 101, 102).

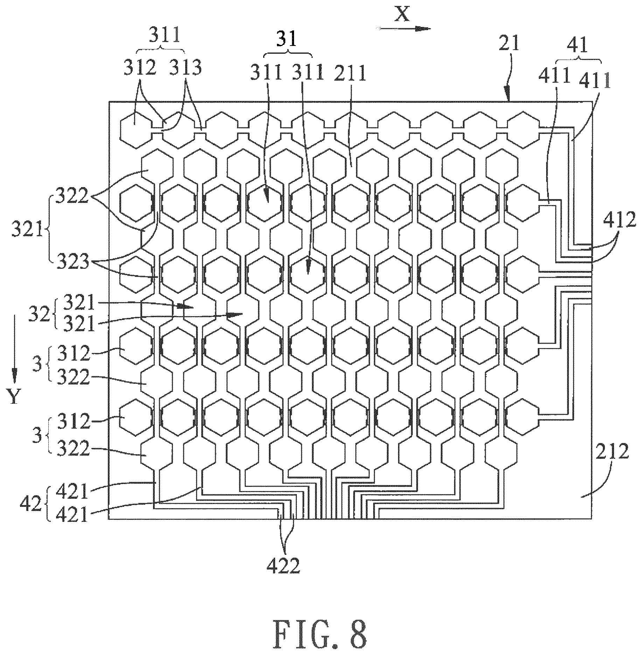

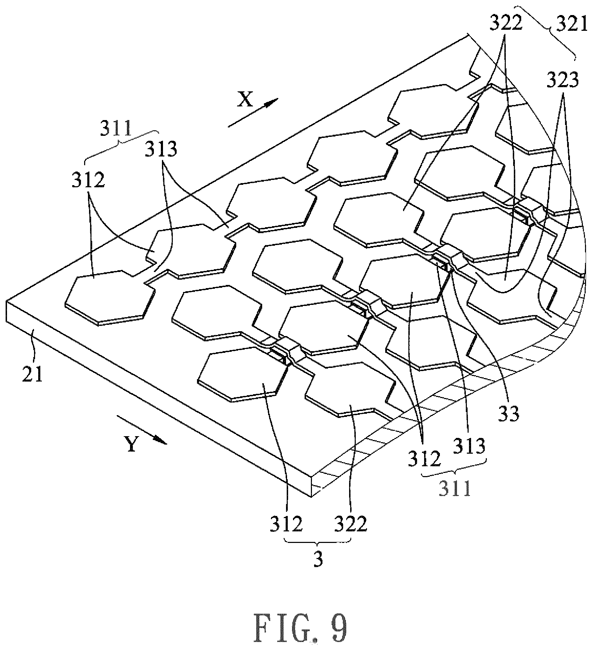

Referring to Figures 8 and 9, the capacitive touch-sensitive device of a fourth exemplary embodiment according to the present disclosure is shown to be similar to that of the first exemplary embodiment. The differences reside mainly in that the lower transparent substrate 21 of the fourth exemplary embodiment further includes a plurality of insulators 33 (see Figure 8), and that the upper transparent substrate 22 and the lower optical adhesive layer 91 are omitted in the fourth exemplary embodiment. Simply put, the fourth exemplary embodiment of the capacitive touch-sensitive device is configured into a single ITO (SITO) structure

In greater detail, each of the first sensor lines 311 further has a plurality of connecting segments 313 interconnecting the first sensing zones 312, and each of the second sensor lines 321 further has a plurality of connecting segments 323 interconnecting the second sensing zones 322. The first sensor lines 311 extend along the first direction (X) to be disposed at the viewable zone 211 of the lower transparent substrate 21, and are mutually spaced apart in the second direction (Y). The second sensor lines 321 extend along the second direction (Y) to be disposed at the viewable zone 211 of the lower transparent substrate 21, and are mutually spaced apart in the first direction (X), such that the connecting segments 323 of the second sensor lines 321 overlap respectively the connecting segments 313 of the first sensor lines 311. Each of the sensing zones 312 of the first sensor lines 311 cooperates with one of the second sensing zones 322 of an adjacent one of the second sensor lines 321 to constitute the capacitive sensing zone 3.

The first signal lines 411 are disposed at the trace zone 212 of the lower transparent substrate 21, and so do the second signal lines 421. The insulators 33 are correspondingly disposed between the connecting segments 323 of the second sensor lines 321 and the connecting segments 313 of the first sensor lines 311.

The capacitive touch-sensitive device of a fifth exemplary embodiment according to the present disclosure is similar to that of the fourth exemplary embodiment (as shown in Figures 8 and 9), with the only difference residing in that the first conductors 612, 712 of the electrically-conductive adhesive layers 6, 7 are configured as spiked spheres as illustrated in Figure 6.

The capacitive touch-sensitive device of a sixth exemplary embodiment according to the present disclosure is similar to that of the fifth exemplary embodiment (as shown in Figures 8 and 9), with the difference residing in that the first conductors 612, 712 of the electrically-conductive adhesive layers 6, 7 are configured as silver nano-wires (as illustrated in Figure 7).

As shown in Figure 8, the first signal lines 411 and the second signal lines 421 of the fourth, fifth and sixth exemplary embodiment are disposed correspondingly on opposite sides of the lower transparent substrate 21. The first and second signal lines 411, 421 may be disposed on the same side of the lower transparent substrate 21. However, people having ordinary skill in the art will appreciate that, with the same number of the sensor lines in the capacitive touch-sensitive device, when switching from the DITO structure to the SITO structure, the number of signal lines disposed on the lower transparent substrate 21 become relatively large. As such, when the first and second signal lines 411, 421 are all disposed on the same side of the lower transparent substrate 21, the flexible circuit board to be bonded with the first and second signal lines 411, 421 may be too long or occupy too large an area. Therefore, in some embodiments, such as the fourth, fifth or sixth exemplary embodiment, a multilayered flexible circuit board (not shown) formed with copper through holes may be utilized to reduce the cost of the flexible circuit board and to prevent mechanical interference.

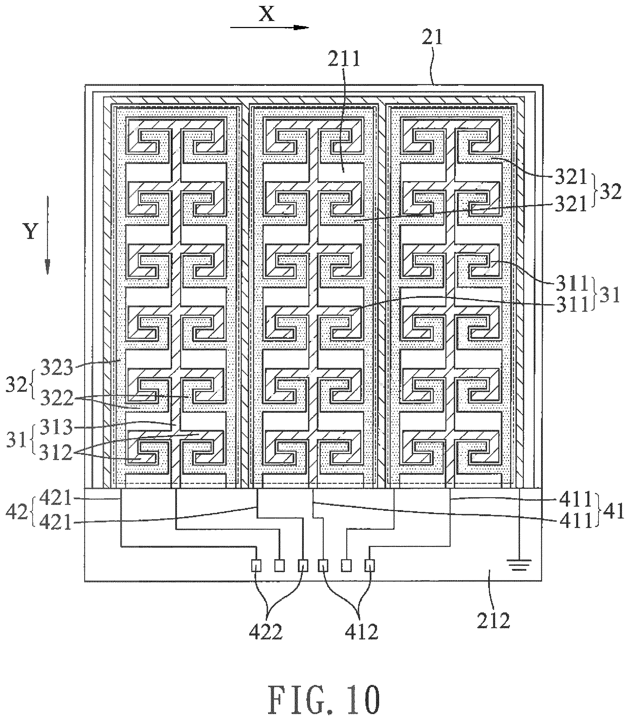

Referring to Figure 10, the capacitive touch-sensitive device of a seventh exemplary embodiment according to the present disclosure is similar to that of the fourth, fifth or sixth exemplary embodiment, with the difference residing in the detail structure of the first and second sensor electrode layers 31, 32.

As shown in Figure 10, the first sensor lines 311 are respectively and coplanarly disposed within the second sensor lines 321 to constitute the viewable zone 211 of the lower transparent substrate 21. Each of the first and second sensor lines 311, 321 substantially extend along the second direction (Y), and are mutually spaced apart in the first direction (X). The connecting segments 313 of each of the first sensor lines 311 extend along the second direction (Y), and the sensing zones 312 of the first sensor lines 311 are spaced apart from each other and extend from the connecting segments 313 in the **first direction (X)** as opposite pairs. The connecting segments 323 of the second sensor lines 321 extend along the second direction (Y) to surround a corresponding one of the first sensor lines 311. The sensing zones 322 of each of the second sensor lines 321 are spaced apart from each other along the second direction (Y) and extend from the corresponding connecting segment 323 as opposite pairs toward a corresponding pair of the connecting segments 312 of the first sensor lines 311. Each of the sensing zones 312 of the first sensor lines 311 and an adjacent one of the sensing zones 322 of the second sensor lines 321 are complementary in shape.

To sum up, by tuning the dispersion density, the average diameter and/or the arrangement of the first conductors 612, 712 and utilizing the metal nano-wires (such as silver nano-wires) as the first and second signal lines 411, 421 of the lower and upper signal trace layers 41, 42, the conducting areas between the first conductors 612, 712 and the outer terminal portions 412, 422 of the lower and upper signal trace layers 41, 42 can be effectively increased, so as to improve the bridging efficiency between the first and second signal lines 411, 421 and the lower and upper flexible circuit board 51, 52 and to prevent the occurrence of the pad-to-pad or line-to-line conductance. As such, the aforesaid problems such as open circuit and signal instability can thus be alleviated.

## Claims

1. A capacitive touch-sensitive device, comprising:
a transparent substrate (21, 22);
a sensor electrode layer (31, 32) disposed on said transparent substrate and including a plurality of mutually electrically isolated sensor lines (311, 321);
a signal trace layer (41, 42) disposed on said transparent substrate and including a plurality of mutually electrically isolated signal lines (411, 421), each having an outer terminal portion (412, 422) that is coupled to a respective one of said sensor lines of said sensor electrode layer (31, 32);
a flexible circuit board (51, 52) having a plurality of mutually electrically isolated bonding pads (511, 521), each corresponding in position to said outer terminal portion of a respective one of said signal lines (411, 421) of said signal trace layer (41, 42); and
an electrically-conductive adhesive layer (6, 7) disposed between said outer terminal portions (412, 422) of said signal trace layer (41, 42) and said flexible circuit board (51, 52) **characterized by** the electrically-conductive adhesive layer including a plurality of first zones (61, 71) that are spaced apart from each other and that respectively correspond to said outer terminal portions (412, 422) of said signal trace layer, each of said first zones (61, 71) having a first adhesive matrix and a plurality of first conductors (612, 712) dispersed in said first adhesive matrix,
wherein said first conductors of each of said first zones electrically bridge the respective one of said outer terminal portions (412, 422) of said signal trace layer (41, 42) to a respective one of said bonding pads (511, 521) of said flexible circuit board (51, 52); and wherein
said electrically-conductive adhesive layer (6, 7) further includes a plurality of second zones (62, 72) that are respectively disposed between adjacent pairs of said first zones (61, 71), each of said second zones (62, 72) having a second adhesive matrix and a plurality of second conductors (622, 722) dispersed in said second adhesive matrix; and
a dispersion density of said first conductors (612, 712) in each of said first zones (61, 71) is greater than that of said second conductors (622, 722) in said each of said second zones (62, 72); wherein the dispersion density describes the number of conductors per unit area of the surface of the electrically-conductive adhesive layer.

2. The capacitive touch-sensitive device according to Claim 1, wherein:
the dispersion density of said first conductors (612, 712) in each of said first zones (61, 71) ranges from 750 N(number)/mm² to 4500 N/mm²; and
the dispersion density of said second conductors (622, 722) in each of said second zones (62, 72) is lower than 750 N/mm².

3. The capacitive touch-sensitive device according to Claim 1 or 2, wherein said first conductors (612, 712) of each of said first zones are mutually electrically coupled, and said second conductors (622, 722) of each of said second zones (62, 72) are mutually electrically isolated.

4. The capacitive touch-sensitive device according to Claim 3, wherein said first conductors (612, 712) are configured as spheres, spiked spheres, or wires

5. The capacitive touch-sensitive device according to Claim 4, wherein said first conductors (612, 712) are configured in the spherical shape and have an average diameter ranging from 20 µm to 45 µm, said first conductors in each of said first zones (61, 71) being arranged into multiple rows in which said first conductors (612, 712) contact each other and being arranged parallel to an axial direction of each of said outer terminal portions.

6. The capacitive touch-sensitive device according to Claim 4, wherein said first conductors (612, 712) are configured as wires and are arranged parallel to an axial direction of each of said outer terminal portions.

7. The capacitive touch-sensitive device according to one of the preceding claims, wherein said signal lines (411, 421) of said signal trace layer (41, 42) are made from silver nano-wires.

8. The capacitive touch-sensitive device according to Claim 7, wherein said silver nano-wires of said signal trace layer (41, 42) have a diameter ranging from 20 µm to µm.

9. The capacitive touch-sensitive device according to Claim 7 or 8, wherein a conducting area between said first conductors (612, 712) of each of said first zones (61, 71) and the respective one of said outer terminal portions (412, 422) of said signal trace layer (41, 42) is greater than 500 µm².

10. The capacitive touch-sensitive device according to one of the preceding claims, wherein said sensor lines (311, 321) are defined into a plurality of first sensor lines and a plurality of second sensor lines, each of the first and second sensor lines having a plurality of mutually spaced-apart sensing zones (312, 322), and a connecting segment interconnecting said sensing zones, said first sensor lines (311) and said second sensor lines (321) being coplanar, each of said sensing zones of said first sensor lines and a adjacent one of said sensing zones of said second sensor lines are complementary in shape.

## Patentansprüche

1. Kapazitive berührungsempfindliche Vorrichtung, die Folgendes umfasst:
ein transparentes Substrat (21, 22);
eine Sensorelektrodenschicht (31, 32), die auf dem transparenten Substrat angeordnet ist und eine Mehrzahl von untereinander elektrisch isolierten Sensorleitungen (311, 321) umfasst;
eine Signalspurschicht (41, 42), die auf dem transparenten Substrat angeordnet ist und eine Mehrzahl von untereinander elektrisch isolierten Signalleitungen (411, 421) umfasst, von der eine jede einen äußeren Anschlussabschnitt (412, 422) hat, der mit einer Zugehörigen der genannten Sensorleitungen der Sensorelektrodenschicht (31, 32) gekoppelt ist;
eine flexible Leiterplatte (51, 52), die eine Mehrzahl von untereinander elektrisch isolierten Kontaktstellen (bonding pads) (511, 521) hat, die jeweils in ihrer Position dem äußeren Anschlussabschnitt einer Zugehörigen der Signalleitungen (411, 421) der Signalspurschicht (41, 42) entsprechen; und
eine elektrisch leitende Haftschicht (6, 7), die zwischen den äußeren Anschlussabschnitten (412, 422) der Signalspurschicht (41, 42) und der flexiblen Leiterplatte (51, 52) angeordnet ist, **dadurch gekennzeichnet, dass** die elektrisch leitfähige Haftschicht eine Mehrzahl von ersten Zonen (61, 71) umfasst, die voneinander beabstandet sind, und die jeweils den äußeren Anschlussabschnitten (412, 422) der Signalspurschicht entsprechen, wobei eine jede der ersten Zonen (61, 71) eine erste adhäsive Matrix und eine Mehrzahl von ersten Leitern (612, 712) hat, die in der ersten adhäsiven Matrix dispergiert sind, wobei die ersten Leiter einer jeden der ersten Zonen eine elektrische Brücke von dem jeweiligen äußeren Abschlussabschnitt (412, 422) der Signalspurschicht (41, 42) zu dem zugehörigen Kontaktfleck (511, 521) der flexiblen Leiterplatte (51, 52) bildet; und wobei
die elektrisch leitfähige adhäsive Schicht (6, 7) ferner eine Mehrzahl von zweiten Zonen (62, 72) umfasst, die jeweils zwischen benachbarten Paaren von ersten Zonen (61, 71) angeordnet sind, wobei die zweiten Zonen (62, 72) eine zweite adhäsive Matrix und eine Mehrzahl von zweiten Leitern (622, 722) hat, die in der zweiten adhäsiven Matrix dispergiert sind; und
wobei eine Dispersionsdichte der ersten Leiter (612, 712) in einer jeden der ersten Zonen (61, 71) größer ist, als diejenige der zweiten Leiter (622, 722) in einer jeden der zweiten Zonen (62, 72); wobei die Dispersionsdichte die Anzahl von Leitern pro Flächeneinheit der Oberfläche der elektrisch leitfähigen Haftschicht ist.

2. Kapazitive berührungsempfindliche Vorrichtung nach Anspruch 1, wobei die Dispersionsdichte der ersten Leiter (612, 712) in einer jeden der ersten Zonen (61, 71) in einem Bereich von 750 N(Anzahl)/mm² bis 4500 N/mm² liegt; und
die Dispersionsdichte der zweiten Leiter (622, 722) in einer jeden der zweiten Zonen (62, 72) geringer ist als 750 N/mm².

3. Kapazitive berührungsempfindliche Vorrichtung nach Anspruch 1 oder 2, wobei die ersten Leiter (612, 712) einer jeden der ersten Zonen miteinander elektrisch gekoppelt sind, und die zweiten Leiter (622, 722) einer jeden der zweiten Zonen (62, 72) voneinander elektrisch isoliert sind.

4. Kapazitive berührungsempfindliche Vorrichtung nach Anspruch 3, wobei die ersten Leiter (612, 712) als Kugeln, Kugeln mit Spitzen oder Drähte konfiguriert sind.

5. Kapazitive berührungsempfindliche Vorrichtung nach Anspruch 4, wobei die ersten Leiter (612, 712) kugelförmig konfiguriert sind und einen mittleren Durchmesser von zwischen 20 µm und 45 µm haben; wobei die ersten Leiter in einer jeden der ersten Zone (61, 71) in mehreren Reihen angeordnet sind, in denen die ersten Leiter (612, 712) sich berühren und die parallel zu einer axialen Richtung eines jeden der äußeren Anschlussabschnitte angeordnet sind.

6. Kapazitive berührungsempfindliche Vorrichtung nach Anspruch 4, wobei die ersten Leiter (612, 712) als Drähte konfiguriert sind und parallel zu einer axialen Richtung eines jeden der äußeren Anschlussabschnitte angeordnet sind.

7. Kapazitive berührungsempfindliche Vorrichtung nach einem der vorhergehenden Ansprüche, wobei die Signalleitungen (411, 421) der Signalspurschicht (41, 42) aus Silber-Nanodrähten gebildet sind.

8. Kapazitive berührungsempfindliche Vorrichtung nach Anspruch 7, wobei die Silber-Nanodrähte der Signalspur (41, 42) einen Durchmesser von zwischen 20 µm und 80 µm haben.

9. Kapazitive berührungsempfindliche Vorrichtung nach Anspruch 7 oder 8, wobei ein leitender Bereich zwischen den ersten Leitern (612, 712) einer jeden der ersten Zonen (61, 71) und dem Zugehörigen der äußeren Anschlussabschnitte (412, 422) der Signalspurschicht (41, 42) größer als 500 µm² ist.

10. Kapazitive berührungsempfindliche Anordnung nach einem der vorhergehenden Ansprüche, wobei die Sensorleitungen (311, 321) in einer Mehrzahl von ersten Sensorleitungen und einer Mehrzahl von zweiten Sensorleitungen definiert sind, wobei eine jede der ersten und zweiten Sensorleitungen eine Mehrzahl von gegenseitig beabstandeten Sensorzonen (312, 322) und ein verbindendes Segment, welches die Sensorzone verbindet, hat, wobei die ersten Sensorleitungen (311) und die zweiten Sensorleitungen (321) koplanar sind, wobei eine jede der Sensorzonen der ersten Sensorleitungen und eine Angrenzende der Sensorzonen der zweiten Sensorleitungen von komplementärer Form sind.

## Revendications

1. Dispositif tactile capacitif, comprenant :
un substrat transparent (21, 22) ;
une couche d'électrode de détection (31, 32) disposée sur ledit substrat transparent et comportant une pluralité de lignes de détection (311, 321) isolées électriquement les unes des autres ;
une couche de trace de signalisation (41, 42) disposée sur ledit substrat transparent et comportant une pluralité de lignes de signalisation (411, 421) isolées électriquement les unes des autres, chacune possédant une partie formant borne externe (412, 422) qui est couplée à une ligne respective desdites lignes de détection de ladite couche d'électrode de détection (31, 32) ;
une carte de circuit souple (51, 52) possédant une pluralité de plots de connexion (511, 521) isolés électriquement les uns des autres, chacun ayant une position correspondant à celle de ladite partie formant borne externe d'une ligne respective desdites lignes de signalisation (411, 421) de ladite couche de trace de signalisation (41, 42) ; et
une couche adhésive électroconductrice (6, 7) disposée entre lesdites parties formant bornes externes (412, 422) de ladite couche de trace de signalisation (41, 42) et ladite carte de circuit souple (51, 52) étant **caractérisée en ce que** la couche adhésive électroconductrice comporte une pluralité de premières zones (61, 71) qui sont séparées les unes des autres et qui correspondent respectivement auxdites parties formant bornes externes (412, 422) de ladite couche de trace de signalisation, chacune desdites premières zones (61, 71) possédant une première matrice adhésive et une pluralité de premiers conducteurs (612, 712) dispersés dans ladite première matrice adhésive, dans lequel lesdits premiers conducteurs de chacune desdites premières zones reliant électriquement la partie respective desdites parties formant bornes externes (412, 422) de ladite couche de trace de signalisation (41, 42) à un plot respectif desdits plots de connexion (511, 521) de ladite carte de circuit souple (51, 52) ; et dans lequel
ladite couche adhésive électroconductrice (6, 7) comporte en outre une pluralité de secondes zones (62, 72) qui sont disposée respectivement entre des paires adjacentes desdites premières zones (61, 71), chacune desdites secondes zones (62, 72) possédant une seconde matrice adhésive et une pluralité de seconds conducteurs (622, 722) dispersés dans ladite seconde matrice adhésive ; et
une densité de dispersion desdits premiers conducteurs (612, 712) dans chacune desdites premières zones (61, 71) est supérieure à celle desdits seconds conducteurs (622, 722) dans ladite chacune desdites secondes zones (62, 72) ; dans lequel la densité de dispersion désigne le nombre de conducteurs par unité d'aire de la surface de la couche adhésive électroconductrice.

2. Dispositif tactile capacitif selon la revendication 1, dans lequel :
la densité de dispersion desdits premiers conducteurs (612, 712) dans chacune desdites premières zones (61, 71) va de 750 N(nombre)/mm² à 4500 N/mm² ; et
la densité de dispersion desdits seconds conducteurs (622, 722) dans chacune desdites secondes zones (62, 72) est inférieure à 750 N/mm².

3. Dispositif tactile capacitif selon la revendication 1 ou 2, dans lequel lesdits premiers conducteurs (612, 712) de chacune desdites premières zones sont couplés électriquement les uns aux autres, et lesdits seconds conducteurs (622, 722) de chacune desdites secondes zones (62, 72) sont isolés électriquement les uns des autres.

4. Dispositif tactile capacitif selon la revendication 3, dans lequel lesdits premiers conducteurs (612, 712) sont configurés sous forme de sphères, de sphères à pointes, ou de fils.

5. Dispositif tactile capacitif selon la revendication 4, dans lequel lesdits premiers conducteurs (612, 712) sont configurés sous la forme sphérique et ont un diamètre moyen allant de 20 µm à 45 µm, lesdits premiers conducteurs dans chacune desdites premières zones (61, 71) étant agencés en rangées multiples dans lesquelles lesdits premiers conducteurs (612, 712) se touchent et sont agencés parallèlement à une direction axiale de chacune desdites parties formant bornes externes.

6. Dispositif tactile capacitif selon la revendication 4, dans lequel lesdits premiers conducteurs (612, 712) sont configurés sous forme de fils et sont agencés parallèlement à une direction axiale de chacune desdites parties formant bornes externes.

7. Dispositif tactile capacitif selon l'une des revendications précédentes, dans lequel lesdites lignes de signalisation (411, 421) de ladite couche de trace de signalisation (41, 42) sont constituées de nanofils d'argent.

8. Dispositif tactile capacitif selon la revendication 7, dans lequel lesdits nanofils d'argent de ladite couche de trace de signalisation (41, 42) ont un diamètre allant de 20 µm à 80 µm.

9. Dispositif tactile capacitif selon la revendication 7 ou 8, dans lequel une zone conductrice entre lesdits premiers conducteurs (612, 712) de chacune desdites premières zones (61, 71) et la partie respective desdites parties formant bornes externes (412, 422) de ladite couche de trace de signalisation (41, 42) mesure plus de 500 µm².

10. Dispositif tactile capacitif selon l'une des revendications précédentes, dans lequel lesdites lignes de détection (311, 321) se divisent en une pluralité de premières lignes de détection et une pluralité de secondes lignes de détection, chacune des premières et secondes lignes de détection possédant une pluralité de zones de détection (312, 322) séparées les unes des autres, et un segment de liaison reliant lesdites zones de détection entre elles, lesdites premières lignes de détection (311) et lesdites secondes lignes de détection (321) étant coplanaires, chacune desdites zones de détection desdites premières lignes de détection et une zone adjacente desdites zones de détection desdites secondes lignes de détection ont des formes complémentaires.
